# FASCICULE DE BREVET EUROPEEN

(11) **EP 1 891 676 B1**
(45) Date de publication et mention de la délivrance du brevet: **12.11.2008**
(21) Numéro de dépôt: 06763718.1
(22) Date de dépôt: 14.06.2006
(51) Int. Cl.: H01L 27/146, H01L 31/0216

(54) **DETECTEUR DE RAYONNEMENT**
STRAHLUNGSDETEKTOR
RADIATION DETECTOR

(30) Priorité: 17.06.2005 FR 0506179
(43) Date de publication de la demande: 27.02.2008
(73) Titulaire: Trixell S.A.S., 38430 Moirans (FR)
(72) Inventeur: VIGNOLLE, Jean-Michel, F-38430 Saint Jean De Moirans (FR)
(74) Mandataire: Collet, Alain
(86) Numéro de dépôt international: PCT/EP2006/063222
(87) Numéro de publication internationale: WO 2006/134131

(56) Documents cités:
- WO-A-95/23348
- US-A- 4 835 595
- US-A- 4 980 553
- US-A- 4 985 619
- US-A- 6 020 590

## Description

La présente invention concerne les détecteurs de rayonnement comportant un capteur photosensible associé à un convertisseur de rayonnement généralement appelé scintillateur. Les domaines d'application de ce type de détecteur sont notamment la radiologie : radiographie, fluoroscopie, mammographie, mais également le contrôle non destructif.

De tels détecteurs de rayonnement sont connus par exemple par le brevet français FR 2 605 166 dans lequel un capteur formé de photodiodes en silicium amorphe est associé à un convertisseur. D'autres types de capteurs comportant par exemple des phototransistors peuvent également être utilisés pour mettre en oeuvre l'invention. Le document WO-A-95/23348 décrit un détecteur comportant un capteur photosensible. Le document US-A-4 980 553 décrit un détecteur d'image comportant un scintillateur.

Le fonctionnement et la structure d'un tel détecteur de rayonnement vont être rappelés succinctement.

Le capteur photosensible est généralement réalisé à partir d'éléments photosensibles à l'état solide arrangés en matrice. Ces éléments ne sont pas sensibles directement aux rayonnements de longueurs d'ondes très courtes comme le sont les rayons X ou gamma. C'est pourquoi, on associe le capteur photosensible au convertisseur de rayonnement qui comporte une couche d'une substance scintillatrice. Cette substance a la propriété, lorsqu'elle est excitée par de tels rayonnements, d'émettre un rayonnement de longueur d'onde supérieure (de la lumière visible ou proche du visible), auquel est sensible le capteur. La lumière émise illumine les éléments photosensibles du capteur qui effectuent une conversion photoélectrique et délivrent des signaux électriques exploitables par des circuits appropriés.

Pour obtenir une bonne collection de la lumière émise par le convertisseur vers le capteur, on donne au convertisseur et au capteur sensiblement la même taille et on les couple optiquement par proximité. Le matériau de couplage, air ou colle, possède une épaisseur faible devant la résolution spatiale de l'ensemble pour dégrader le moins possible la qualité de l'image délivrée par le capteur.

Les éléments photosensibles sont réalisés à partir de matériaux semi-conducteurs, le plus souvent du silicium monocristallin pour les capteurs de type CCD ou CMOS, du silicium polycristallin ou amorphe. Un élément photosensible comporte au moins une photodiode, un phototransistor ou une photorésistance. Ces éléments sont arrangés en matrice et déposés sur un substrat, par exemple formé au moyen d'une dalle de verre.

Le capteur peut être réalisé à l'aide de plusieurs substrats raboutés portant chacun des éléments photosensibles. Une telle structure est par exemple décrite dans les brevets français publiés sous les numéros FR 2 758 654 et FR 2 758 656.

Certaines substances scintillatrices de la famille des halogénures alcalins ou des oxysulfures de terres rares sont fréquemment employées pour leurs bonnes performances.

L'iodure de césium dopé au sodium ou au thallium selon que l'on souhaite une émission vers 400 nanomètres ou vers 550 nanomètres respectivement, est connu pour sa forte absorption des rayons X et pour son excellent rendement de fluorescence. Il se présente sous la forme de fines aiguilles que l'on fait croître sur un support. Ces aiguilles sont sensiblement perpendiculaires à ce support et elles confinent en partie la lumière émise vers le capteur. Leur finesse conditionne la résolution du détecteur. Les oxysulfures de lanthane et de gadolinium sont aussi très employés pour les mêmes raisons.

Le rayonnement généré par le scintillateur n'est pas absorbé complètement par le capteur. Une partie du rayonnement traverse le capteur, se propage et revient plus loin dans la matrice du capteur, créant un signal artificiel. Cela a pour effet de créer des artéfacts visibles par exemple au niveau des raboutages du substrat ce qui dégrade la qualité de l'image. Cette dégradation est notamment mesurable par une baisse de la fonction de transfert de modulation bien connue dans la littérature anglo-saxonne sous le nom de "Modulation-Transfer Function (MTF)" et de l'efficacité quantique de détection bien connue dans la littérature anglo-saxonne sous le nom de "Detective Quantum Efficiency (DQE)".

L'invention vise à pallier ce problème en évitant les réflexions du rayonnement issu du scintillateur.

A cet effet, l'invention a pour objet un détecteur de rayonnement comportant un scintillateur et un capteur photosensible couplés optiquement par proximité, le capteur photosensible comprenant des éléments photosensibles rangés en matrice et séparés les uns des autres par des interstices, **caractérisé en ce qu**'il comporte en outre un filtre opaque au rayonnement émis par le scintillateur, le filtre recouvrant les interstices entre les éléments photosensibles.

L'invention sera mieux comprise et d'autres avantages apparaîtront à la lecture de la description détaillée d'un mode de réalisation donné à titre d'exemple, description illustrée par le dessin joint dans lequel :
la figure 1 représente un détecteur de rayonnement ne comportant pas de filtre ;
la figure 2 représente un détecteur conforme à l'invention.

Dans le différentes figures, les échelles ne sont pas respectées et pour ne pas surcharger les figures, seuls quelques éléments photosensibles d'une matrice ont été représentés.

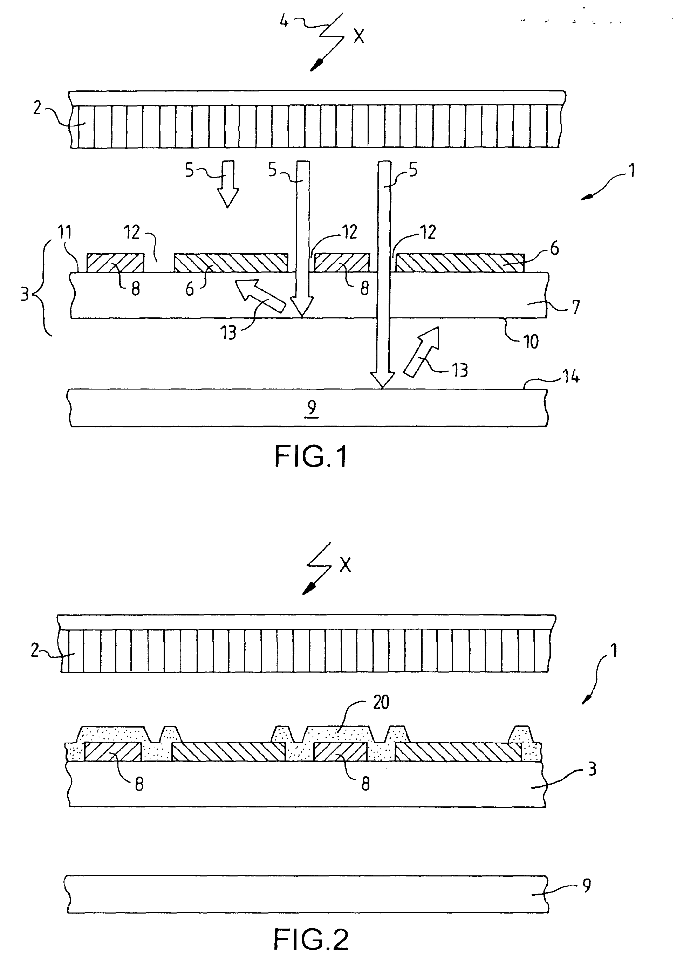

La figure 1 représente un détecteur 1 de rayonnement X par exemple utilisé en radiologie médicale. Le détecteur 1 comporte un scintillateur 2 et un capteur photosensible 3 couplés optiquement par proximité par exemple par collage avec une colle transparente. Le scintillateur 2 transforme un rayonnement X 4 en un rayonnement visible 5 auquel le capteur 3 est sensible. Le capteur 3 comporte des éléments photosensibles 6 arrangés en matrice. Ces éléments comprennent par exemple chacun un phototransistor ou une photodiode sensible au rayonnement émis par le scintillateur 2. Les éléments photosensibles 6 sont portés par un substrat 7 formé par exemple par une dalle de verre, le capteur 3 comporte des conducteurs 8 de lignes et de colonnes de la matrice alimentant chaque élément photosensible 6. Le détecteur comporte avantageusement une source de lumière 9 émettant un rayonnement auquel le capteur est sensible, la source de lumière 9 étant susceptible d'éclairer simultanément tous les éléments photosensibles 6. La source de lumière 9 permet, en éclairant de façon uniforme tous les éléments photosensibles 6, de remettre à zéro les charges accumulées par les éléments photosensibles lors d'une prise d'image. La source de lumière 9 éclaire le capteur 3 par sa face arrière 10, par opposition avec une face avant 11 du capteur 3, par laquelle le capteur 3 reçoit le rayonnement 5 du scintillateur 2. On utilise la transparence de la dalle de verre formant le substrat 7 pour transmettre l'éclairement de la source de lumière 9 vers les éléments photosensibles.

Le rayonnement 5 est émis par le scintillateur 2 en direction du capteur 3 vers sa face 11 et passe par endroit entre les éléments photosensibles 6 dans des interstices 12 située entre les éléments photosensibles 6. La partie du rayonnement 5 passant dans les interstices 12 forment des réflexions parasites 13 sur différentes surfaces du détecteur 1. Ces surfaces sont par exemple les faces 10 et 11 du substrat 7 ou encore une face 14 de la source de lumière 9. Les réflexions parasites 13 peuvent éclairer directement ou indirectement après plusieurs réflexions des éléments photosensibles 6 quelques fois éloignés de l'élément photosensible 6 directement en regard de la zone du scintillateur 2 où le rayonnement 5 a été émis. Les réflexions parasites 13 dégradent la qualité de l'image réalisée par le détecteur 1. Cette dégradation est notamment visible par une perte de netteté de contours dans l'image réalisée par le détecteur 1.

Selon l'invention, le détecteur 1 comporte un filtre 20 opaque au rayonnement 5 émis par le scintillateur 2. Le filtre 20 recouvre les interstices 12 entre les éléments photosensibles 6. Le filtre 20 est visible sur la figure 2. Le filtre 20 permet de supprimer la partie du rayonnement 5 passant dans les interstices 12 et par conséquent les réflexions parasites 13.

Avantageusement, le filtre 20 recouvre les conducteurs 8 de lignes et de colonnes de la matrice. En effet les conducteurs 8 peuvent réfléchir une partie du rayonnement 5 et créer ainsi de nouvelles réflexions parasites 13. Lorsque le filtre 20 recouvre les conducteurs 8, ces nouvelles réflexions parasites sont évitées.

Avantageusement, le filtre 20 recouvre partiellement les éléments photosensibles. Ce recouvrement partiel permet tout d'abord de s'assurer du recouvrement total des interstices 12 et des conducteurs 8. Le recouvrement permet en outre le réglage fin de la quantité de charges accumulées par l'élément photosensible 6 lors de la prise d'image. Plus précisément, l'élément photosensible 6 forme une capacité se chargeant lors d'une phase de prise d'image par des photons émis par le scintillateur 2. La phase de prise d'image est suivie d'une phase de lecture des éléments photosensibles 6 lors de laquelle chaque capacité est déchargée dans un circuit de lecture au travers des conducteurs 8. Les éléments photosensibles 6 sont réalisés à partir de matériaux semi-conducteurs. Le mode de réalisation de ces éléments ne permet pas de régler finement la capacité de l'élément photosensible 6. En recouvrant partiellement par le filtre 20, opaque aux photons émis par le scintillateur 2 on ne modifie pas la capacité de l'élément photosensible 6 mais on peut diminuer la sensibilité de l'élément photosensible 6. On peut ainsi adapter la dose de photons détectable par l'élément photosensible 6 sans atteindre sa saturation. On augmente ainsi la dynamique du détecteur 1.

L'invention peut être mise en oeuvre sans source de lumière 9. Il suffit alors d'utiliser un filtre 20 de couleur noire c'est à dire complètement opaque à tout rayonnement. En revanche en présence d'une source de lumière 9, on choisit avantageusement un filtre 20 transparent au rayonnement émis par la source de lumière 9. Par exemple, on choisit un scintillateur 2 comportant de l'iodure de césium dopée au sodium qui émet un rayonnement 5 centrée autour de 550 nm c'est à dire de couleur verte. On choisit une source de lumière 9 formée d'une pluralité de diodes électroluminescentes de couleur rouge émettant entre 650 et 700 nm. Dans cette configuration de scintillateur 2 et de source de lumière 9, on choisit un filtre 20 de couleur rouge. Le filtre 20 sera opaque au rayonnement 5 émis par le scintillateur 2 et transparent à l'éclairement de la source de lumière 9. Avantageusement, le filtre 20 comporte une résine pigmentée. Une épaisseur comprise entre 1 et 2 µm suffit pour ne transmettre que 2% hors de la bande de fréquence choisie. La résine peut être déposée sur le capteur 3 par photolithographie.

## Revendications

1. Détecteur (1) de rayonnement comportant un scintillateur (2) et un capteur photosensible (3) couplés optiquement par proximité, le capteur photosensible (3) comprenant des éléments photosensibles (6) rangés en matrice et séparés les uns des autres par des interstices (12), **caractérisé en ce qu'**il comporte en outre un filtre (20) opaque au rayonnement (5) émis par le scintillateur (2), le filtre (20) recouvrant les interstices (12) entre les éléments photosensibles (6).

2. Détecteur selon la revendication 1, **caractérisé en ce que** le capteur photosensible (3) comporte des conducteurs (8) de lignes et de colonnes de la matrice et **en ce que** le filtre (20) recouvre les conducteurs (8) de lignes et de colonnes.

3. Détecteur selon l'une des revendications précédentes, **caractérisé en ce que** le filtre (20) recouvre partiellement les éléments photosensibles (6).

4. Détecteur selon l'une des revendications précédentes, **caractérisé en ce qu'**il comporte une source de lumière (9) émettant un rayonnement auquel le capteur (3) est sensible, la source de lumière (9) étant susceptible d'éclairer simultanément tous les éléments photosensibles (6), et **en ce que** le filtre (20) est transparent au rayonnement émis par la source de lumière (9).

5. Détecteur selon l'une des revendications précédentes, **caractérisé en ce que** le filtre (20) comporte une résine pigmentée.

6. Détecteur selon la revendication 5, **caractérisé en ce que** la résine a une épaisseur comprise entre 1 et 2 µm.

7. Détecteur selon l'une des revendications 5 ou 6, **caractérisé en ce que** la résine est déposée sur le capteur (3) par photolithographie.

## Claims

1. Radiation detector (1) comprising a scintillator (2) and a photosensitive sensor (3) optically coupled by proximity, the photosensitive sensor (3) comprising photosensitive elements (6) arranged in a matrix and separated from one another by gaps (12), **characterized in that** it also comprises a filter (20) that is opaque to the radiation (5) emitted by the scintillator (2), the filter (20) covering the gaps (12) between the photosensitive elements (6).

2. Detector according to Claim 1, **characterized in that** the photosensitive sensor (3) comprises row and column conductors (8) of the matrix and **in that** the filter (20) covers the row and column conductors (8).

3. Detector according to either of the preceding claims, **characterized in that** the filter (20) partially covers the photosensitive elements (6).

4. Detector according to one of the preceding claims, **characterized in that** it comprises a light source (9) emitting radiation to which the sensor (3) is sensitive, the light source (9) being capable of illuminating all the photosensitive elements (6) simultaneously, and **in that** the filter (20) is transparent to the radiation emitted by the light source (9).

5. Detector according to one of the preceding claims, **characterized in that** the filter (20) comprises a pigmented resin.

6. Detector according to Claim 5, **characterized in that** the resin has a thickness in the range from 1 to 2 µm.

7. Detector according to either of Claims 5 and 6, **characterized in that** the resin is deposited onto the sensor (3) by photolithography.

## Patentansprüche

1. Strahlungsdetektor (1), umfassend einen Szintillator (2) und einen lichtempfindlichen Sensor (3), die berührungslos optisch gekoppelt sind, wobei der lichtempfindliche Sensor (3) lichtempfindliche Elemente (6) umfasst, die matrizenartig geordnet und voneinander durch Zwischenräume (12) getrennt sind, **dadurch gekennzeichnet, dass** er außerdem ein Filter (20) umfasst, das für die Strahlung (5) undurchlässig ist, die von dem Szintillator (2) emittiert wird, wobei das Filter (20) die Zwischenräume (12) zwischen den lichtempfindlichen Elementen (6) abdeckt.

2. Detektor nach Anspruch 1, **dadurch gekennzeichnet, dass** der lichtempfindliche Sensor (3) Leiter (8) von Reihen und Spalten der Matrize umfasst, und dass das Filter (20) die Leiter (8) der Reihen und Spalten abdeckt.

3. Detektor nach einem der vorhergehenden Ansprüche, **dadurch gekennzeichnet, dass** das Filter (20) die lichtempfindlichen Elemente (6) teilweise abdeckt.

4. Detektor nach einem der vorhergehenden Ansprüche, **dadurch gekennzeichnet, dass** er eine Lichtquelle (9) umfasst, die eine Strahlung emittiert, auf die der Sensor (3) anspricht, wobei die Lichtquelle (9) in der Lage ist, alle lichtempfindlichen Elemente (6) gleichzeitig zu beleuchten, und dass das Filter (20) für die von der Lichtquelle (9) emittierte Strahlung durchlässig ist.

5. Detektor nach einem der vorhergehenden Ansprüche, **dadurch gekennzeichnet, dass** das Filter (20) ein pigmentiertes Harz umfasst.

6. Detektor nach Anspruch 5, **dadurch gekennzeichnet, dass** das Harz eine Dicke zwischen 1 und 2 µm aufweist.

7. Detektor nach einem der Ansprüche 5 oder 6, **dadurch gekennzeichnet, dass** das Harz durch Photolithographie auf dem Sensor (3) abgeschieden wird.
